# EUROPEAN PATENT APPLICATION

(11) **EP 4 576 453 A1**
(43) Date of publication of application: **25.06.2025**
(21) Application number: 23219676.6
(22) Date of filing: 22.12.2023
(51) Int. Cl.: H01S 5/02, H01S 5/20, H01S 5/22, H01S 5/343

(54) **ELECTRO-OPTICAL DEVICE BASED ON III-V AND/OR II-VI AND/OR GROUP IV SEMICONDUCTORS AND METHOD**

(71) Applicant: Imec VZW, 3001 Leuven (BE); Katholieke Universiteit Leuven, 3000 Leuven (BE); Universiteit Gent, 9000 Gent (BE)
(72) Inventor: Swekis, Peter, 1190 Brussels (BE); Colucci, Davide, 1000 Brussel (BE); Van Campenhout, Joris, 3001 Leuven (BE); Kunert, Bernardette, 3012 Wilsele (BE); Yudistira, Didit, 3010 Kessel-Lo (BE); Panda, Debi Prasad, 382355 Gandhinagar (IN); Caer, Charles, 1180 Uccle (BE)
(74) Representative: Roth, Sebastian

(57) **Abstract**

An electro-optical device (10) comprises a support region (11) and a ridge structure (12) extending from the support region. The ridge structure comprises: a bottom region (13) provided on the support region and comprising at least one layer of a first semiconductor material that has a first conductivity type; an intermediate region (14) provided on the bottom region and comprising an active region (15), wherein the intermediate region further comprises at least one layer of a second semiconductor material, and has a trapezoid-shaped top region (16) with a top surface (17), side surfaces (18), and inclined surfaces (19) connecting the top surface to the side surfaces; a capping layer (20) provided on the side surfaces and the inclined surfaces and comprising at least one layer of a third semiconductor material that has a higher band-gap than the second semiconductor material; and a fin structure (21) extending upwards from the top region and comprising at least one layer of a fourth semiconductor material that has a second conductivity type.

## Description

### TECHNICAL FIELD

The present invention provides an electro-optical device based on III-V and/or II-VI and/or group IV semiconductors and comprising a ridge structure. The invention also proposes a method for fabricating the electro-optical device.

### BACKGROUND

Semiconductor nano-ridge waveguides with a good current injection efficiency and/or limited non-radiative recombination, are used in monolithically integrated photonic devices.

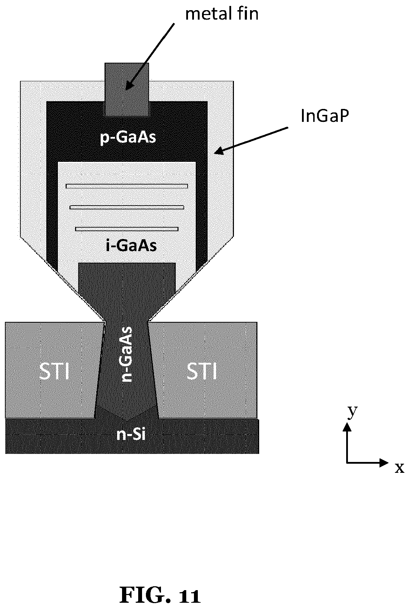

An example of a monolithic integrated electro-optical device fabricated with a nano-ridge engineering (NRE) approach is depicted in FIG. 11. The electro-optical device includes a III-V semiconductor material ridge structure (e.g. GaAs), which is grown in a narrow Shallow Trench Isolation (STI) trench on a silicon (Si) V-groove formed in a Si support layer.

The STI trench has a high aspect ratio (i.e. a ratio of its depth vs. its width is larger than at least 1), which has the advantage that misfits and dislocation defects are efficiently trapped (thus called aspect ratio trapping, ART) during the growth of the III-V semiconductor material inside the trench, and therefore the outgrown III-V semiconductor ridge material, i.e. a freestanding ridge structure, is free of defects. The nano-ridge shape on top of the STI trenches can be engineered and manipulated by the applied growth conditions, hence, this ridge integration approach is called NRE.

In the electro-optical device of FIG. 11, the support layer is highly n-doped, (i.e., doped with n-type impurities) and the ridge structure itself comprises an n-doped III-V semiconductor material (e.g. GaAs) region arranged near the bottom of the ridge structure and contacting the n-doped support layer in the trench.

Further, the ridge structure comprises a III-V semiconductor material (e.g. GaAs) region arranged in the center of the ridge structure that is unintentionally doped (also referred to as non-intentionally doped or NID), and containing an active region. The ridge structure also comprises a p-doped III-V semiconductor material (e.g. GaAs) region arranged at the top of the ridge structure that is in contact with a metallic interface.

In the electro-optical device according to FIG. 11, the ridge structure has a substantially rectangular shape, in particular in the top or upper region (that is, the region opposite to the Si support layer in the exemplary coordinate system depicted in FIG. 11).

Further, the ridge structure comprises a capping layer of a higher band-gap III-V material with respect to the preceding layer (e.g. InGaP, lattice matched to e.g. the GaAs of the ridge structure) grown around the III-V semiconductor material ridge structure, particularly around a wider portion thereof. The capping layer has a conduction and/or valence band offset, which is sufficiently high to prevent at least one species of charge carriers (i.e. electrons and/or holes) to penetrate into the capping layer and to reach its surface interface with a dielectric, which encapsulates the ridge structure and the capping layer.

Further, the ridge structure according to FIG. 11 includes a region near the top of the ridge structure where III-V semiconductor material was removed by etching, in order to form a narrower top portion referred to as metal fin or metal fin structure. Here, the purpose of the metal fin structure is to inject carriers into the active region of the ridge structure, in operation of the electro-optical device. Simultaneously, the optical waveguide mode is not pushed downwards but has a strong overlap with the metal fin and the metal-semiconductor interface mentioned above. This overlap causes very strong optical absorption and hinders, e.g., laser operation. To enable laser operation in this design, the metal fin can be replaced by a largely spaced plug array to reduce the optical losses in the metal region. Consequently, the current density in each metal plug must be very high to ensure sufficient current injection to the active region. This, in turn, will cause new problems such as defect formation in the semiconductor close to the metal fin and along the interface, resulting in laser device failure.

### SUMMARY OF THE INVENTION

In view of the above, embodiments of the present invention aim to provide an improved electro-optical device. An objective is to provide an electro-optical device with a ridge structure that shows better contact design properties. Another objective is to reduce surface recombination by preventing exposure of relevant semiconductor material regions, in order to maximize charge carrier densities in the active region of the electro-optical device, and to reduce optical losses of light being waveguided in the ridge.

These and other objectives are achieved by the embodiments provided in the enclosed independent claims. Advantageous implementations of these embodiments are described in the dependent claims.

The embodiments are based on the following considerations. In the exemplary cross-section of the electro-optical device shown in FIG. 11, the n-doped layer is arranged on the bottom of the ridge structure, and the p-doped layer is arranged on the top of the ridge structure. This means that electrons are injected into the ridge structure from the bottom and holes are injected from the ridge structure from the top.

Further, this is one critical surface in the electro-optical device shown in FIG. 11, namely any exposed surface e.g. on the top, due to the metal fin structure etch. Surface recombination of carriers could be reduced significantly in this exemplary electro-optical device, if carriers were prevented from reaching any exposed surfaces.

Thus, the embodiments of the present invention are based on the idea of providing a trapezoid-shaped region of the semiconductor ridge structure (made e.g. by GaAs) that encapsulates the active region and is anisotropically capped with another semiconductor material (e.g. InGaP), which, importantly, covers little to no GaAs on the top narrower part of the trapezoid-shaped region. Further, the design of the ridge structure provides a continuous electrical contact to the active region, wherein the contact may employ a semiconductor fin structure placed on top of the trapezoid-shaped region and a continuous metal ridge or an array of metal plugs placed on top of the fin structure.

A first aspect of the invention provides an electro-optical device based on III-V and/or II-VI and/or group IV semiconductors, comprising a support region and a ridge structure extending from the support region. The ridge structure comprises: a bottom region comprising at least one layer of a first semiconductor material, the first semiconductor material having a first impurity type, the bottom region being provided on the support region; an intermediate region comprising at least one layer of a second semiconductor material, the intermediate region being provided on the bottom region and comprising an active region, wherein the intermediate region has a trapezoid-shaped top region with a top surface, side surfaces, and inclined surfaces that connect the top surface to the side surfaces; a capping layer comprising at least one layer of a third semiconductor material, the capping layer being provided on the side surfaces and the inclined surfaces of the intermediate region, wherein the third semiconductor material has a higher band-gap than the second semiconductor material; and a fin structure comprising at least one layer of a fourth semiconductor material having a second impurity type, the fin structure extending primarily upwards from the top region of the intermediate region.

Depending on the conditions of forming the ridge structure (i.e. the growth conditions), a layer/region provided on top of another layer/region may cover any exposed surface of the region/layer below only partly or completely. Also, a thickness of the layer/region on the surface of the region/layer below it can be controlled, particularly relative to the thickness of the layer/region on the other surfaces of the region/layer beneath it.

In this document, the terms "upwards", "top", "above" etc. relate to the terms "downwards", "bottom", "below" etc. according to a fabrication direction, e.g. by epitaxial growth, of the electro-optical device. That is, the "lowest" point of the ridge structure is on the support region, and the support region is "below" the ridge structure. The ridge structure extends "upwards" from the support region, and the fin structure is provided "on top" and "above" the ridge structure.

In the electro-optical device of the first aspect, and in this document, the "first conductivity type" may be an n-type or p-type, and a "second-conductivity-type" may accordingly be a p-type or n-type. Likewise, "first-conductivity-type charge carriers" maybe electrons or holes, and "second-conductivity-type charge carriers" may accordingly be holes or electrons.

By shaping the top of the intermediate region of the ridge structure with a trapezoid form, and by providing the capping layer to cover little to no second semiconductor material on the top surface of said trapezoid-shaped intermediate region (i.e., by providing the capping layer only on the side surfaces and the inclined surfaces of the intermediate region), a good carrier injection into the active region is allowed during operation of the electro-optical device while maintaining sufficient surface passivation and good carrier confinement.

Further, by using a higher-band-gap-material for the capping layer around the lower-band-gap-material of the intermediate region, surface passivation is maintained, and the subsequent carrier injection into the active region as well as carrier confinement may be optimized.

Further, the design utilizes a continuous contact ridge by forming the semiconductor fin structure on the top surface of the trapezoid-shaped top region of the intermediate region, thereby enabling the electro-optical device, when in operation, to confine current injection, pull down the optical mode to reduce optical losses, increase the separation from the metal/semiconductor interface to the optical gain region to reduce non-radiative carrier recombination and defect formation, and hence, prevent excessive current and temperature gradients, which may lead to device failure. In an example, one or more metal plugs are further arranged on the fin structure.

In addition, the electro-optical device can be processed in one epitaxial growth step and no regrowth is needed. Moreover, integration of the electro-optical device is simplified, resulting in reduced costs.

In an implementation form of the first aspect, the top surface of the intermediate region comprises a {001} surface of the second semiconductor material.

In an implementation form of the first aspect, the inclined surfaces of the intermediate region comprise {111} surfaces of the second semiconductor material.

In an implementation form of the first aspect, the fin structure is provided directly on the top surface of the intermediate region.

In an implementation form of the first aspect, the capping layer is further provided on the top surface of the intermediate region; and the fin structure is provided directly on the capping layer on the top surface of the intermediate region.

In an implementation form of the first aspect, the ridge structure further comprises a transition layer provided between the top surface of the intermediate region and the capping layer.

During the formation of the ridge structure, some of the third semiconductor material of the capping layer may be provided also onto the top surface of the intermediate region. Hence, further carrier confinement of the top surface and an improved carrier injection towards the intermediate region can be achieved by growing the transition layer between the top surface of the intermediate region and the capping layer.

Thereby, carrier injection into the active region while maintaining surface passivation and good carrier confinement is ensured.

In an implementation form of the first aspect, a width of the fin structure is narrower than a width of the capping layer.

In an implementation form of the first aspect, the electro-optical device further comprises an electrode electrically contacting a top surface of the fin structure and configured to inject second-conductivity-type charge carriers into the ridge structure through the fin structure.

In an implementation form of the first aspect, the bottom region of the ridge structure is narrower than the intermediate region of the ridge structure.

In an implementation form of the first aspect, the active region comprises one or more quantum wells and/or one or more quantum dots and/or one or more quantum wires and/or a bulk material.

In an implementation form of the first aspect, the first semiconductor material comprises at least one of: doped GaAs, doped InP, doped InAs, doped GaSb, doped InGaAs, doped InGaAsSb, or doped, or doped GaAlAs.

In an implementation form of the first aspect, the second semiconductor material comprises at least one of: unintentionally doped or doped GaAs, unintentionally doped or doped InP, unintentionally doped or doped InAs, unintentionally doped or doped GaSb, unintentionally doped or doped InGaAs, unintentionally doped or doped InGaAsSb, or unintentionally doped or doped InGaAsP, or unintentionally doped or doped InGaAsN.

In an implementation form of the first aspect, the third semiconductor material comprises at least one of: unintentionally doped or doped AlAsSb, unintentionally doped or doped InGaP, unintentionally doped or doped AlGaSb, unintentionally doped or doped GaAlPSb, or unintentionally doped or doped InAlAs, or unintentionally doped or doped GaAlAs.

In an implementation form of the first aspect, the fourth semiconductor material comprises at least one of: doped GaAs, doped InP, doped InAs, doped GaSb, doped InGaAs, doped InGaAsSb, or doped GaAlAs

In an implementation form of the first aspect, the electro-optical device is a laser, a light emitting diode (LED), an optical amplifier, a single photon source, an optical modulator, a saturable absorber, or an optical detector.

A second aspect of the invention provides a method for fabricating an electro-optical device based on III-V and/or II-VI and/or group IV semiconductors. The method comprises providing a support region; and growing a ridge structure extending from the support region by: growing a bottom region onto the support region, the bottom region comprising at least one layer of a first semiconductor material having a first conductivity type; growing an intermediate region onto the bottom region, the intermediate region comprising an active region, and the intermediate region comprising at least one layer of a second semiconductor material, wherein the intermediate region has a trapezoid-shaped top region with a top surface, side surfaces, and inclined surfaces that connect the top surface to the side surfaces; growing a capping layer onto the side surfaces and the inclined surfaces of the intermediate region, the capping layer comprising at least one layer of a third semiconductor material, wherein the third semiconductor material has a higher band-gap than the second semiconductor material; and forming a fin structure onto the top region of the intermediate region, the fin structure comprising at least one layer of a fourth semiconductor material, the fourth semiconductor material having a second impurity type.

In an implementation form of the second aspect, the top surface of the intermediate region comprises a {001} surface of the second semiconductor material.

In an implementation form of the second aspect, the inclined surfaces of the intermediate region comprise {111} surfaces of the second semiconductor material.

In an implementation form of the second aspect, the method further comprises forming the fin structure directly on the top surface of the intermediate region.

In an implementation form of the second aspect, the method further comprises growing the capping layer onto the top surface of the intermediate region; and forming the fin structure directly on the capping layer on the top surface of the intermediate region.

In an implementation form of the second aspect, the method further comprises forming a transition layer between the top surface of the intermediate region and the capping layer.

In an implementation form of the second aspect, a width of the fin structure is narrower than a width of the capping layer.

In an implementation form of the second aspect, the method further comprises depositing an electrode electrically contacting a top surface of the fin structure and configured to inject second-conductivity-type charge carriers into the ridge structure through the fin structure.

In an implementation form of the second aspect, the bottom region of the ridge structure is narrower than the intermediate region of the ridge structure.

In an implementation form of the second aspect, the active region comprises one or more quantum wells and/or one or more quantum dots and/or one or more quantum wires and/or a bulk material.

In an implementation form of the second aspect, the first semiconductor material comprises at least one of: doped GaAs, doped InP, doped InAs, doped GaSb, doped InGaAs, doped InGaAsSb, or doped, or doped GaAlAs

In an implementation form of the second aspect, the second semiconductor material comprises at least one of: unintentionally doped or doped GaAs, unintentionally doped or doped InP, unintentionally doped or doped InAs, unintentionally doped or doped GaSb, unintentionally doped or doped InGaAs, unintentionally doped or doped InGaAsSb, or unintentionally doped or doped InGaAsP, or unintentionally doped or doped InGaAsN.

In an implementation form of the second aspect, the third semiconductor material comprises at least one of: unintentionally doped or doped AlAsSb, unintentionally doped or doped InGaP, unintentionally doped or doped AlGaSb, unintentionally doped or doped GaAlPSb, or unintentionally doped or doped InAlAs, or unintentionally doped or doped GaAlAs.

In an implementation form of the second aspect, the fourth semiconductor material comprises at least one of: doped GaAs, doped InP, doped InAs, doped GaSb, doped InGaAs, doped InGaAsSb, or doped GaAlAs.

The method of the second aspect achieves the same advantages as the device of the first aspect and maybe extended by respective implementations as described above for the device of the first aspect.

The advantages of the solutions according to the invention can be summarized as follows:
- Good carrier injection efficiency and surface passivation is retained.
- The electro-optical device can be processed in one epitaxial growth step and regrowth is not needed.
- A fin structure is obtained, which confines current injection, pulls down the optical mode to reduce optical losses and increases the separation from the metal/semiconductor interface to the optical gain region reducing the risk of defect formation. Furthermore, due to the reduced losses, it allows the use of a metal ridge or metal plugs for contacting the electro-optical device, preventing excessive current and temperature gradients.

- Simplified integration of the electro-optical device is achieved, which leads to cost reduction.
- Due to the iterative procedure, there is a flexibility in the frame structure.

### BRIEF DESCRIPTION OF THE DRAWINGS

The above described aspects and implementations are explained in the following description of embodiments with respect to the enclosed drawings:
- FIG. 1: shows a cross-section of an electro-optical device according to an embodiment of the invention;
- FIG. 2a)-d): show examples for the trapezoid-shaped form of the intermediate region of an electro-optical device according to an embodiment of the invention;
- FIG. 3: shows a cross-section of an electro-optical device according to an embodiment of the invention;
- FIG. 4: shows a three-dimensional (3D) view of the electro-optical device according to the embodiment of FIG. 3;
- FIG. 5a)-b): show results of a mode profile and an absorption region for an electro-optical device according to an embodiment of the invention;
- FIG. 6: shows a cross-section of an electro-optical device according to an embodiment of the invention;
- FIG. 7: shows a cross-section of an electro-optical device according to an embodiment of the invention;
- FIG. 8: shows a method according to an embodiment of the invention;
- FIG. 9: shows an exemplary method according to an embodiment of the invention;
- FIG. 10: shows an exemplary method according to an embodiment of the invention;
- FIG. 11: shows a conventional example of a semiconductor-based ridge electro-optical device.

The size of elements in the figures are not drawn to scale and may be different compared to a real life implementation in order to highlight details of the embodiments.

### DETAILED DESCRIPTION OF EMBODIMENTS OF THE INVENTION

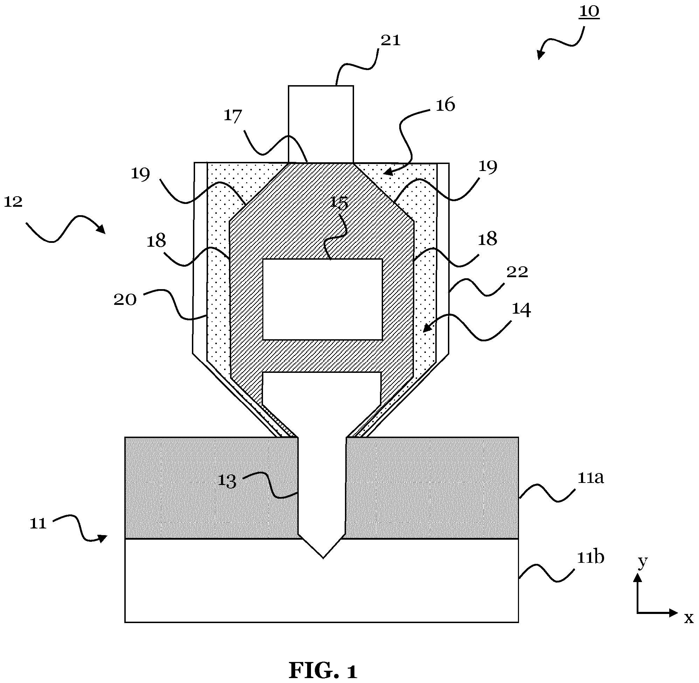

FIG. 1 shows a cross-section of an exemplary embodiment of an electro-optical device 10 according to the invention. The device 10 is a monolithically integrated electro-optical device, and is based on III-V semiconductors and/or II-VI semiconductors and/or group IV semiconductors.

The electro-optical device 10 may be a laser, a LED, an optical amplifier, a single photon source, an optical modulator, a saturable absorber, or an optical detector. The electro-optical device 10 may be fabricated using the so-called nano-ridge engineering (NRE) approach.

The electro-optical device 10 comprises a support region 11. The support region 11 may comprise a substrate made of Si, or Ge, or SiC, or any binary III-V material or any binary II-IV material. The support region 11 may comprise a narrow STI trench 11a on a V-groove formed in a semiconductor-material substrate 11b.

Further, the support region 11 may be an engineered substrate realized by bonding a crystalline seed layer to a handling substrate and processing a trench-pattern, as the one depicted in FIG. 1. The engineered substrate may provide a crystalline surface for epitaxial deposition of the other parts of the electro-optical device 10.

The electro-optical device 10 further comprises a ridge structure 12 extending from the support region 11. The ridge structure 12 may be fabricated using the NRE approach on the support region 11, i.e. may be grown in a high-aspect-ratio trench that is formed before in the support region 11. The ridge structure 12 may extend on the support region 11 along a direction, which is into the plane depicted in the cross-section shown in FIG. 1, where a reference coordinate system is depicted.

The ridge structure 12 includes a plurality of different regions and layers. Namely, the ridge structure 12 includes a bottom region 13, which is provided on the support region 11. The bottom region 13 comprises at least one layer of a first semiconductor material, the first semiconductor material having a first impurity type.

The bottom region 13 may be grown in the high-aspect ratio trench mentioned above. The bottom region 13, thus, may be narrower compared to a maximum width of the ridge structure 12.

The ridge structure 12 further comprises an intermediate region 14 provided on the bottom region 13 and comprises an active region 15. The intermediate region 14 comprises, or is made of, at least one layer of a second semiconductor material.

The active region 15 can emit or absorb or modulate light, and may comprise at least one layer comprising one or more quantum wells and/or one or more quantum dots and/or one or more quantum wires and/or a bulk material.

Notably, the intermediate region 14 is formed so that it has a trapezoid-shaped top region 16. That is, the top region 16 (or upper part) of the intermediate region 14 has two side surfaces 18, a top surface 17 and two inclined surfaces 19 that connect the top surface 17 to the side surfaces 18. In this manner, the intermediate region 14 has an upper part which, in the plane of the cross-section shown in FIG. 1, has the shape of a trapezoid, where the top surface 17 has a width (in the x axis depicted in the coordinate system of FIG. 1) that is smaller than a total width of the intermediate region 14. The total width of the intermediate region 14 may be determined, for example, as being a distance between the two side surfaces 18 (in the x-direction in the coordinate system depicted in FIG. 1).

Accordingly, in three-dimensions (3D), the top region 16 of the intermediate region 14 may have a truncated-pyramidal shape.

In the embodiment according to FIG. 1, the top surface 17 of the intermediate region 14 may comprise a {001} surface of the second semiconductor material, and the inclined surfaces 19 may comprise each a {111} surface of the second semiconductor material.

Optionally, the side surfaces 18 may comprise each a {110} surface of the second semiconductor material.

The lower part of the intermediate region 14 may have an inverted trapezoid-shape, compared to the trapezoid defined in the upper part (or top region 16), as depicted in the embodiment according to FIG. 1, with two lower inclined surfaces and a bottom surface, where the lower inclined surfaces connect the bottom surface to the two side surfaces 18. Alternatively, the lower part of the intermediate region 14 may have any other shape. For example, it may have a rectangular or squared shape (in two dimensions or 2D, and it has then a rectangular-box shape or cubic-box shape, respectively, in 3D). This is not limited in this disclosure.

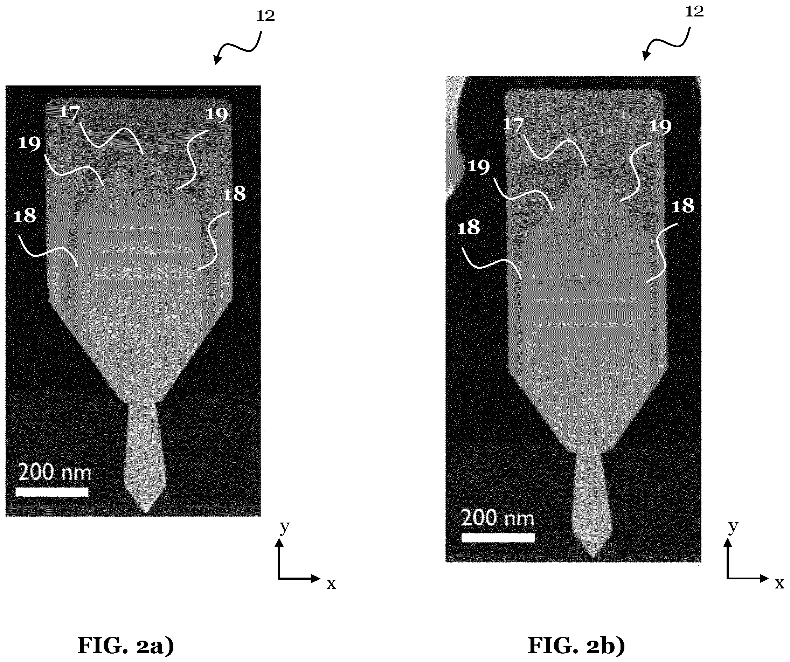

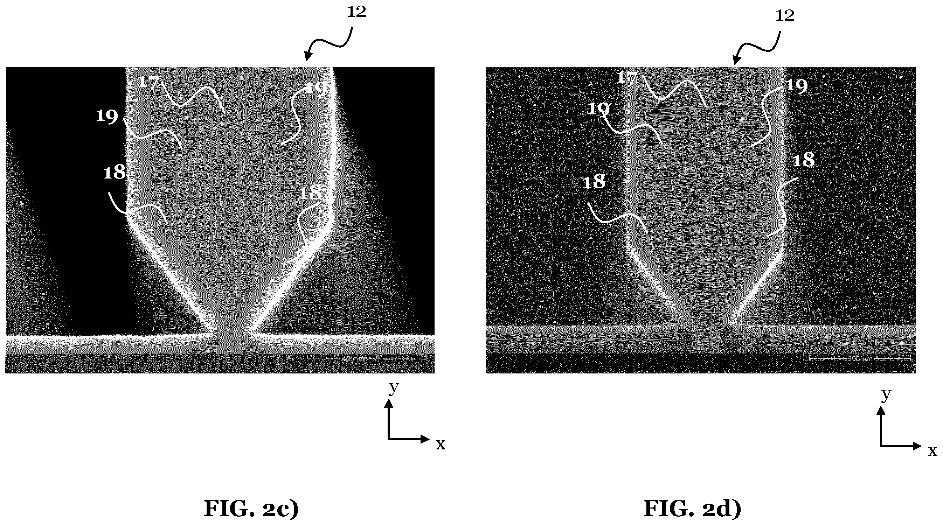

FIG. 2a - d) show four examples for the intermediate region 14, each having a trapezoid shape. The top surface 17 of the intermediate region 14 shown in FIG. 2a) and FIG. 2d) have a width larger than the top surface 17 of the intermediate region 14 shown in FIG. 2b). The top surface 17 of the intermediate region 14 shown in FIG. 2 c) highlights the absence of any capping layer, as will be explained later on in this document. Same elements in FIG. 1 and FIG. 2a)-d) share the same reference signs and function likewise.

Referring to FIG. 1, the ridge structure 12 further comprises a capping layer 20 that is provided on the side surfaces 18 and the inclined surfaces 19 of the intermediate region 14. The capping layer comprises at least one layer of a third semiconductor material, wherein the third semiconductor material has a higher band-gap than the second semiconductor material.

Thereby, the {001} facet of the second semiconductor material of the intermediate layer 14 is not covered by the capping layer, i.e. remains exposed.

The ridge structure 12 further comprises a fin structure 21 that comprises, or is made of, at least one layer of a fourth semiconductor material, the fourth semiconductor material having a second impurity type. The fin structure 21 extends upwards from the top region 16 of the intermediate region 14. One or more metal plugs or metal structures may be arranged on the fin structure 21 (not shown).

In this exemplary embodiment, since the capping layer 20 is not provided on the top surface 17 of the top region 16 of the intermediate region 14, the fin structure 21 is thus provided directly on the top surface 17 of the intermediate region 14, thereby allowing a good carrier injection into the active region whilst maintaining sufficient surface passivation and good carrier confinement.

Further, a width of the fin structure 21 is narrower than a width of the capping layer 20

As mentioned above, the bottom region 13 may be narrower compared to the maximum width of the ridge structure 12. That is, the bottom region 13 may be narrower compared to the total width of the intermediate region 14 and a width of the capping layer 20 provided on each of the side surfaces 18 of the intermediate region 14. Accordingly, the bottom region 13 may be narrower compared to the total width of the intermediate region 14.

The ridge structure 12 may further comprise at least one layer 22 of the fourth semiconductor material provided on the capping layer 20 that in turn is provided on the side surfaces 18 of the intermediate region 14, as depicted in the embodiment of FIG. 1. This may be formed due to the fabrication of the fin structure 21, as will be explained later on in this document, and does not limit the operation of the electro-optical device 10.

The first semiconductor material may comprise at least one of: doped GaAs, doped InP, doped InAs, doped GaSb, doped InGaAs, doped InGaAsSb, or doped, or doped GaAlAs.

The second semiconductor material of the intermediate region 14 may comprise at least one of: unintentionally doped or doped GaAs, unintentionally doped or doped InP, unintentionally doped or doped InAs, unintentionally doped or doped GaSb, unintentionally doped or doped InGaAs, unintentionally doped or doped InGaAsSb, or unintentionally doped or doped InGaAsP, or unintentionally doped or doped InGaAsN.

The third semiconductor material of the capping layer 20 may comprise at least one of: unintentionally doped or doped AlAsSb, unintentionally doped or doped InGaP, unintentionally doped or doped AlGaSb, unintentionally doped or doped GaPSb, or unintentionally doped or doped InAlAs, or unintentionally doped or doped GaAlAs.

The fourth semiconductor material of the fin structure 21 may comprise at least one of: doped GaAs, doped InP, doped InAs, doped GaSb, doped InGaAs, doped InGaAsSb, or doped, or unintentionally doped or doped GaAlAs.

As mentioned above, the electro-optical device 10 maybe a laser, a LED, an optical amplifier, a single photon source, an optical modulator, a saturable absorber, or an optical detector. Hence, a choice of the first semiconductor material, the second semiconductor material, the third semiconductor material and the fourth semiconductor material, depend on the desired implementation/usage of the electro-optical device 10 and may be defined to ensure good wave guidance for the relevant wavelength required for the respective device implementation/usage.

Exemplary materials used for the ridge structure 12 so that the electro-optical device 10 is, for example and not as a limitation, a GaAs Laser, a InGaAs Laser, and InP Laser, or a GaSb laser are shown in Table I.

**Table I. Examples for the semiconductor materials used in possible lasers based on the electro-optical device 10.**

| | **GaAs Laser** | **InGaAs Laser** | **InP Laser** | **GaSb Laser** |
|---|---|---|---|---|
| Bottom region | n-GaAs | n-In_{0.2}Ga_{0.8}As | n-InP | n-GaSb |
| Intermediate region | GaAs | InGaAs | InP | GaSb |
| Active region | Quantum wells: In_{0.2}Ga_{0.8}As Quantum dots: InAs | Quantum wells: In_{0.45}Ga_{0.55}As Quantum dots: InAs | Quantum wells: In_{0.5}Ga_{0.5}As Quantum wells: GaInAsP | Quantum wells: InₓGa₁₋ₓSb_{1-y}As_{y} (0·15<x<0.4, 0.1<y<0.45) |
| Capping layer | In_{0.49}Ga_{0.51}P | In_{0.70}Ga_{0.30}P | In_{0.52}Al_{0.48}As | AlAs_{0..08}Sb_{0.92} |
| Fin structure | p-GaAs | p-In_{0.2}Ga_{0.8}As | p-InP | p-GaSb |
| Wavelength range | 950-1360 nm | 1260-1600 nm | 1400-1700 nm | 1900-3000 nm |

Similarly, the respective dimension of the bottom region 13, the intermediate region 14, the capping layer 20 and the fin structure 21 may vary depending on the desired use of the electro-optical device 10 and, thus, on the employed semiconductor materials.

As an example and not as a limitation, when the electro-optical device 10 is a GaAs/InGaAs Laser, a width of the fin structure 21 may be larger than 5 nanometers (nm) and smaller than a largest width at which the fin structure 21 does not guide waves of the respective material. An upper limit for the width of the fin structure 21 for the GaAs/InGaAs Laser is ~250 nm.

Accordingly, a width of the top surface 17 of the intermediate region 14 may be larger or smaller than the width of the fin structure 21 and smaller than the maximum width of the intermediate region 14. Further, a width of the capping layer 20 that is provided on the side surfaces 18 and on the inclined surfaces 19 of the intermediate region 14 may be above 10 nm.

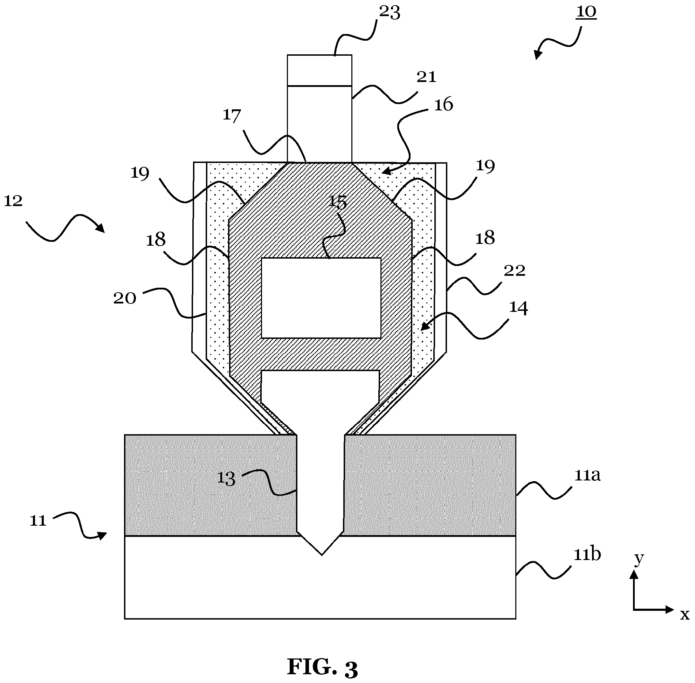

FIG. 3 shows a cross-section of an exemplary embodiment of an electro-optical device 10 according to the invention, which builds on the electro-optical device 10 shown in FIG. 1. Same elements share the same reference signs and function likewise. Hereinafter, only the differences between FIG. 1 and FIG. 3 are explained.

In the embodiment according to FIG. 3, the electro-optical device 10, in particular the ridge structure 12, further comprises an electrode 23 electrically contacting a top surface of the fin structure 21.

The electrode 23 is configured to inject second-conductivity-type charge carriers into the ridge structure 12, in particular into the intermediate region 14, through the fin structure 21. The electrode 23 may comprise, or maybe made of, a metallic material.

In the electro-optical device 10 according to FIG. 1 and FIG. 3 the first-conductivity-type may be n-type and the second-conductivity-type may be p-type. First-conductivity-type charge carriers are thus electrons, and second-conductivity-type charge carriers are holes. However, these polarities can also be exchanged.

Due to the trapezoid-shape of the top region of the intermediate region 14, the fin structure 21 enables the electro-optical device 10 to confine current injection, pull down the optical mode to reduce optical losses, increase a separation from the metal/semiconductor interface to the optical active region 15, and prevent excessive current and temperature gradients.

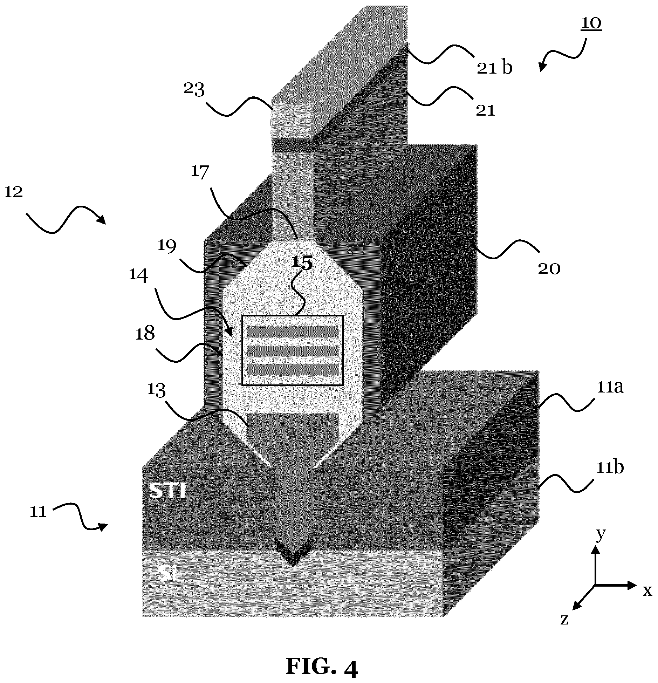

FIG. 4 shows an example of a 3D view of the electro-optical device 10 according to the embodiment of FIG. 3. Same elements in FIG. 3 and FIG. 4 share the same reference signs and function likewise. In this example, the fin structure 21 may further comprise a second layer 21b that maybe made of the fourth semiconductor material having the second impurity type to ensure low contact resistance.

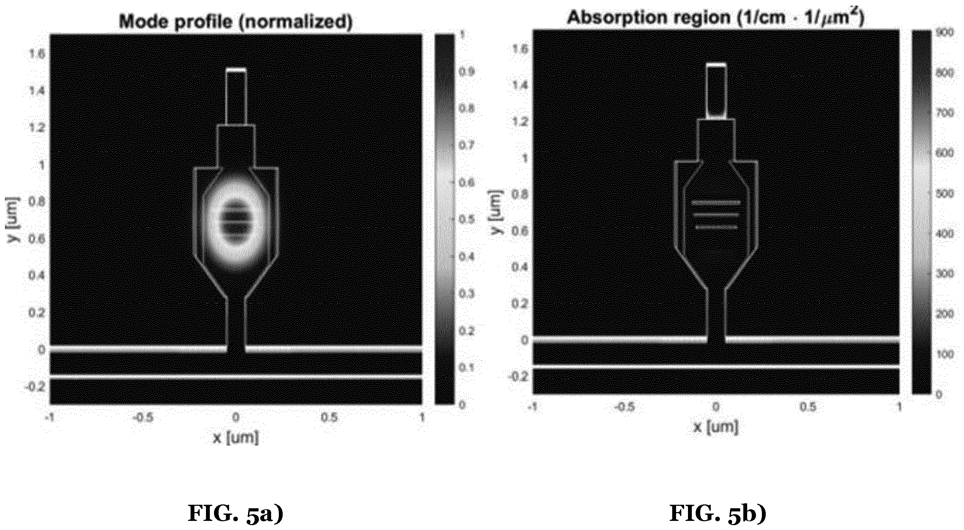

Exemplary simulation results for a mode profile and for an absorption region obtained for the electro-optical device 10 according to the embodiment shown in FIG. 3 and FIG. 4 are shown respectively in FIG. 5a) and FIG. 5b).

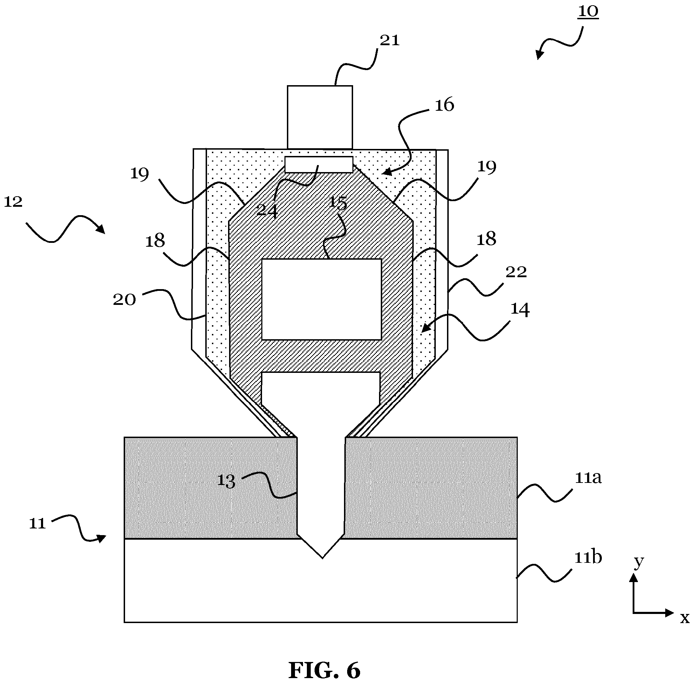

FIG. 6 shows a cross-section of another exemplary embodiment of an electro-optical device 10 according to the invention, which builds on the electro-optical device 10 shown in FIG. 1. Same elements share the same reference signs and function likewise. Hereinafter, only the differences between FIG. 1 and FIG. 6 are explained.

In the embodiment according to FIG. 6, the capping layer 20 is further provided on the top surface 17 of the intermediate region 14. That is, the capping layer 20 covers at least partially or totally the {001} facet of the top surface 17 of the intermediate region 14.

Thus, to maintain sufficient carrier injection into the intermediate region 14, the ridge structure 12 in this exemplary embodiment may further comprise a transition layer 24 that is provided between the top surface 17 of the intermediate region 14 and the capping layer 20 on top of it.

The transition layer 24 may also be unintentionally provided on the inclined surfaces (19) of the intermediate region 14 (not shown) and/or on the side surfaces (18) of the intermediate region 14 (not shown).

The transition layer 24 may comprise, or may be formed of, at least one layer of a fifth semiconductor material. The fifth semiconductor material may comprise the second semiconductor material being doped with first conductivity-type impurities or with second conductivity-type impurities. For example and not as a limitation, the transition layer 24 may comprise n-doped or p-doped GaAs.

Further, in the exemplary embodiment according to FIG. 6, the fin structure 21 is provided directly on the capping layer 20 that is provided on the top surface 17 of the intermediate region 14.

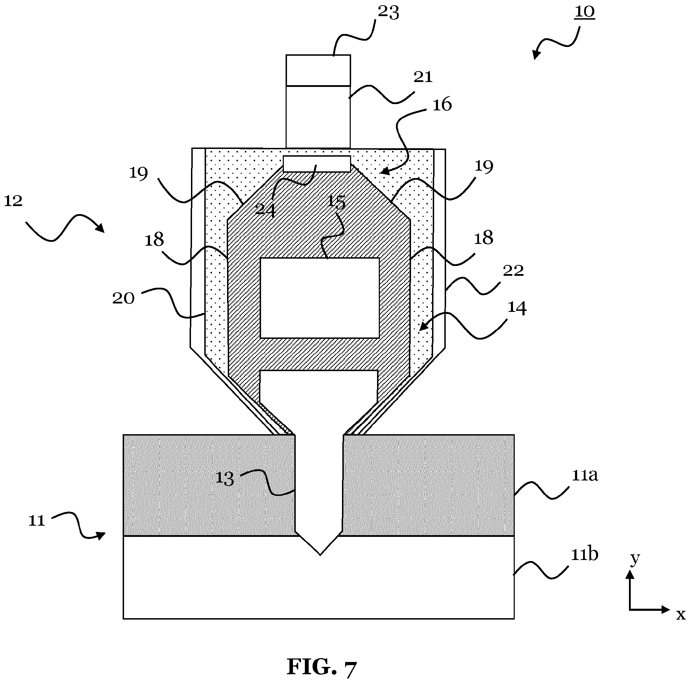

FIG. 7 shows a cross-section of another exemplary embodiment of an electro-optical device 10 according to the invention, which builds on the electro-optical device 10 shown in FIG. 6. Same elements share the same reference signs and function likewise. Hereinafter, only the differences between FIG. 6 and FIG. 7 are explained.

In the embodiment according to FIG. 7, the electro-optical device 10, in particular the ridge structure 12, further comprises an electrode 23 electrically contacting a top surface of the fin structure 21.

In this embodiment, the electrode 23 is configured to inject second-conductivity-type charge carriers into the ridge structure 12, in particular into the intermediate region 14, through the fin structure 21 and through the transition layer 24. The electrode 23 may comprise, or may be made of, a metallic material.

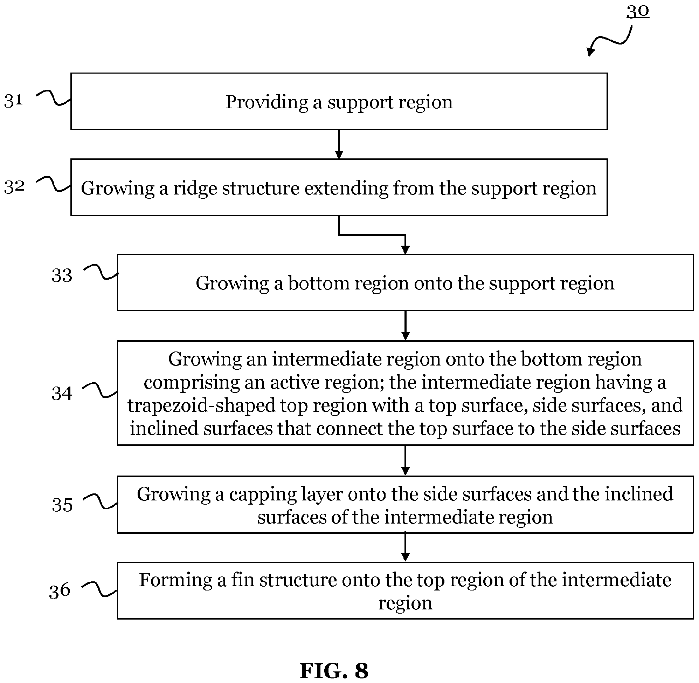

FIG. 8 shows schematically a method 30 for fabricating the electro-optical device 10, according to an embodiment of the invention. The method 30 includes at least the following steps: A step 31 of providing a support region 11, and a step 32 of growing a ridge structure 12 extending from the support region 11.

The step 32 may comprise: A step 33 of growing a bottom region 13 onto the support region 11, the bottom region 13 comprising at least one layer of a first semiconductor material having a first conductivity type; and a step 34 of growing an intermediate region 14 onto the bottom region 13, the intermediate region 14 comprising an active region 15, and the intermediate region 14 comprising at least one layer of a second semiconductor material, wherein the intermediate region 14 has a trapezoid-shaped top region 16 with a top surface 17, side surfaces 18, and inclined surfaces 19 that connect the top surface 17 to the side surfaces 18.

The step 32 may further comprise a step 35 growing a capping layer 20 onto the side surfaces 18 and the inclined surfaces 19 of the intermediate region 14, the capping layer 20 comprising at least one layer of a third semiconductor material, and wherein the third semiconductor material has a higher band-gap than the second semiconductor material.

Then, the step 32 may comprise a step 36 of forming a fin structure 21 onto the top region 16 of the intermediate region 14, the fin structure 21 comprising a fourth semiconductor material having a second conductivity type.

For instance, when the NRE approach is used to produce the electro-optical device 10 according to the embodiments of this invention, a STI trench 11a may be formed in the support region 11, and the ridge structure 12 may be epitaxially grown in the STI trench 11a.

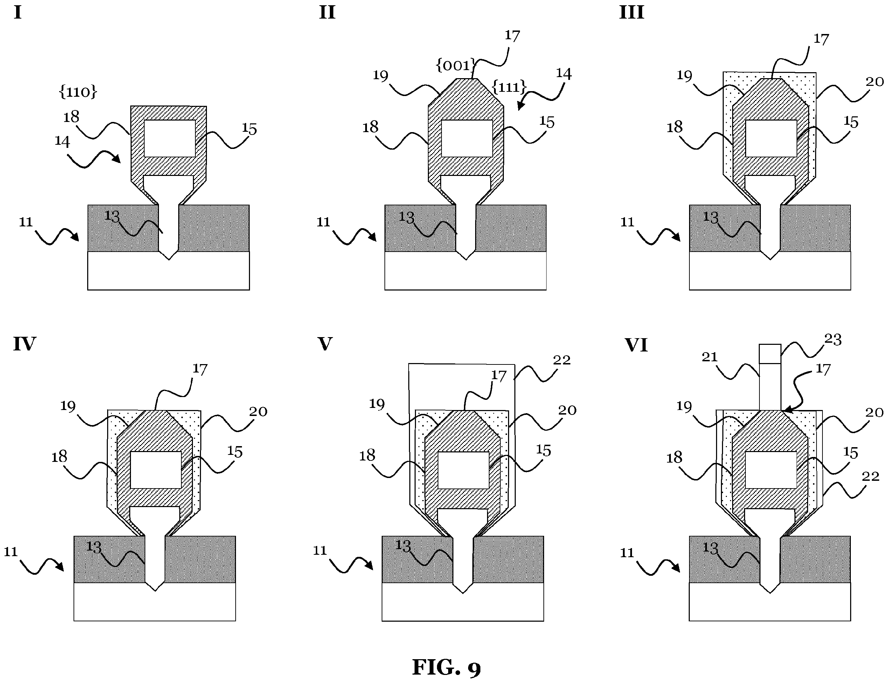

FIG. 9 schematically depicts exemplary steps for the method 32 above. In step I, after the support region 11 is formed, the bottom region 13 can be grown onto the support region 11. Then, a lower part of the intermediate region 14 may be grown onto the bottom region 13, and may be made of the second semiconductor material. This lower part has a substantially rectangular shape. For example, the side surfaces 18 of the intermediate region 14 may comprise {110} surfaces. The active region 15 may also be formed in the intermediate region 14.

Then, in step II, the trapezoid-shaped top region 16 of the intermediate region 14 maybe formed by using a facet growth rate manipulation technique, which is called NRE. That is, the two inclined surfaces 19 may be formed comprising {111} surfaces of the second semiconductor material, and the top surface 17 of the intermediate region 14 maybe formed, comprising a {001} surface of the second semiconductor material, with the inclined surfaces 19 connecting the top surface 17 to the side surfaces 18.

In step III, the capping layer 20 comprising the at least one layer of the third semiconductor material, may be grown onto the side surfaces 18, the inclined surfaces 19 and the top surface 17 of the intermediate region 14. The capping layer 20 onto the top surface 17 may be removed *in situ* (e.g., via annealing or etching within a same growth chamber), in step IV, so that the top surface 17 is exposed.

Next, in steps V and VI, the fin structure 21 is formed by growing at least one layer 22 of the fourth semiconductor material onto the intermediate structure 14 and the capping layer 20. The at least one layer 22 maybe subsequently etched to form the fin structure 21 only onto the top surface 17 of the intermediate layer 14. Further, the electrode 23 may also be formed.

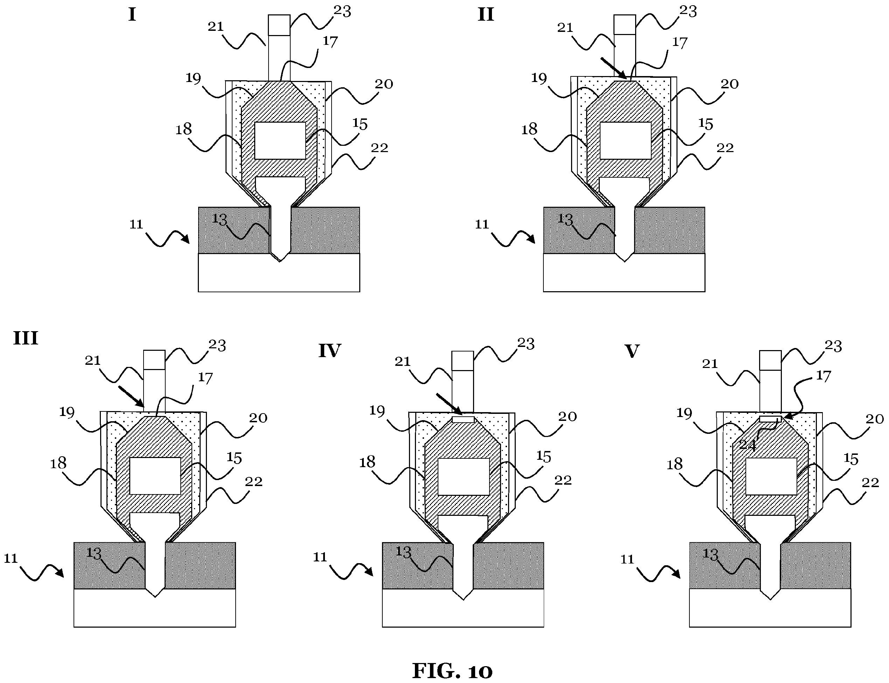

FIG. 10 schematically depicts an exemplary method for the case where the capping layer 20 is still present on the top surface 17 of the intermediate region 14. Step I according to FIG. 10 depicts that the at least one layer 22 may be grown before removing the capping layer 20. Then, in step II, there may be still a part of the capping layer 20 provided onto the top surface 17 of the intermediate layer 14.

In order to maintain sufficient carrier injection in the ridge structure 14, in step III, the capping layer 20 maybe n-doped or p-doped. Additionally or alternatively, in steps IV and V, the transition layer 24 may be formed between the top surface 17 of the intermediate region 14 and the capping layer 20 directly on top of it. For example and not as a limitation, the transition layer 24 may be formed by doping totally or partially the second semiconductor material of the top surface 17 of the trapezoid-shaped top region 16. This is indicated in step IV in FIG. 10.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. An electro-optical device (10) based on III-V and/or II-VI and/or group IV semiconductors, comprising:
a support region (11); and
a ridge structure (12) extending from the support region (11), wherein the ridge structure (12) comprises:
- a bottom region (13) comprising at least one layer of a first semiconductor material, the first semiconductor material having a first impurity type, the bottom region (13) being provided on the support region (11);
- an intermediate region (14) comprising at least one layer of a second semiconductor material, the intermediate region (14) being provided on the bottom region (13) and comprising an active region (15) , wherein the intermediate region (14) has a trapezoid-shaped top region (16) with a top surface (17), side surfaces (18), and inclined surfaces (19) that connect the top surface (17) to the side surfaces (18);
- a capping layer (20) comprising at least one layer of a third semiconductor material, the capping layer (20) being provided on the side surfaces (18) and the inclined surfaces (19) of the intermediate region (14), wherein the third semiconductor material has a higher band-gap than the second semiconductor material; and
- a fin structure (21) comprising at least one layer of a fourth semiconductor material, the fin structure (21) extending primarily upwards from the top region (16) of the intermediate region (14), the fourth semiconductor material having a second impurity type.

2. The electro-optical device (10) according to claim 1, wherein:
the top surface (17) of the intermediate region (14) comprises a {001} surface of the second semiconductor material.

3. The electro-optical device (10) according to claim 1 or 2, wherein:
the inclined surfaces (19) comprise {111} surfaces of the second semiconductor material.

4. The electro-optical device (10) according to one of the claims 1 to 3, wherein the fin structure (21) is provided directly on the top surface (17) of the intermediate region (14).

5. The electro-optical device (10) according to one of the claims 1 to 3, wherein:
- the capping layer (20) is further provided on the top surface (17) of the intermediate region (14); and
- the fin structure (21) is provided directly on the capping layer (20) on the top surface (17) of the intermediate region (14).

6. The electro-optical device (10) according to claim 5, wherein the ridge structure (12) further comprises:
- a transition layer (24) provided between the top surface (17) of the intermediate region (14) and the capping layer (20).

7. The electro-optical device (10) according to one of the claims 5 or 6, wherein a width of the fin structure (21) is narrower than a width of the capping layer (20).

8. The electro-optical device (10) according to one of the preceding claims, further comprising:
an electrode (23) electrically contacting a top surface of the fin structure (21) and configured to inject second-conductivity-type charge carriers into the ridge structure (12) through the fin structure (21).

9. The electro-optical device (10) according to one of the preceding claims, wherein:
the bottom region (13) of the ridge structure (12) is narrower than the intermediate region (14).

10. The electro-optical device (10) according to one of the preceding claims, wherein:
the active region (15) comprises one or more quantum wells and/or one or more quantum dots and/or one or more quantum wires and/or a bulk material.

11. The electro-optical device (10) according to one of the preceding claims, wherein:
the second semiconductor material comprises at least one of: unintentionally doped or doped GaAs, unintentionally doped or doped InP, unintentionally doped or doped InAs, unintentionally doped or doped GaSb, unintentionally doped or doped InGaAs, unintentionally doped or doped InGaAsSb, or unintentionally doped or doped InGaAsP, or unintentionally doped or doped InGaAsN.

12. The electro-optical device (10) according to one of the preceding claims, wherein:
the third semiconductor material comprises at least one of: unintentionally doped or doped AlAsSb, unintentionally doped or doped InGaP, unintentionally doped or doped AlGaSb, unintentionally doped or doped GaPSb, or unintentionally doped or doped InAlAs, unintentionally doped or doped GaAlAs.

13. The electro-optical device (10) according to one of the preceding claims, wherein:
the fourth semiconductor material comprises at least one of: doped GaAs, doped InP, doped InAs, doped GaSb, doped InGaAs, doped InGaAsSb, or doped GaAlAs.

14. The electro-optical device (10) according to one of the preceding claims, being:
a laser, a light emitting diode, an optical amplifier, a single photon source, an optical modulator, a saturable absorber, or an optical detector.

15. A method (30) for fabricating an electro-optical device (10) based on III-V, and/or II-VI and/or group IV semiconductors, the method (30) comprising:
providing (31) a support region (11);
growing (32) a ridge structure (12) extending from the support region (11) by:
- growing (33) a bottom region (13) onto the support region (11), the bottom region (13) comprising at least one layer of a first semiconductor material having a first conductivity type;
- growing (34) an intermediate region (14) onto the bottom region (13), the intermediate region (14) comprising an active region (15), and the intermediate region (14) comprising at least one layer of a second semiconductor material, wherein the intermediate region (14) has a trapezoid-shaped top region (16) with a top surface (17), side surfaces (18), and inclined surfaces (19) that connect the top surface (17) to the side surfaces (18);
- growing (35) a capping layer (20) onto the side surfaces (18) and the inclined surfaces (19) of the intermediate region (14), the capping layer (20) comprising at least one layer of a third semiconductor material, wherein the third semiconductor material has a higher band-gap than the second semiconductor material; and
- forming (36) a fin structure (21) onto the top region (16) of the intermediate region (14), the fin structure (21) comprising at least one layer of a fourth semiconductor material, the fourth semiconductor material having a second impurity type.
